# EUROPÄISCHE PATENTANMELDUNG

(11) **EP 2 584 245 A1**
(43) Veröffentlichungstag der Anmeldung: **24.04.2013**
(21) Anmeldenummer: 11185408.9
(22) Anmeldetag: 17.10.2011
(51) Int. Cl.: F21K 99/00, F21Y 101/02

(54) **LED-Modul mit Kühlblech**

(71) Anmelder: Luminova GmbH, 75196 Remchingen (DE)
(72) Erfinder: Bittighofer, Frank, 75196 Remchingen (DE)
(74) Vertreter: Kramer - Barske - Schmidtchen

(57) **Zusammenfassung**

Die vorliegende Erfindung betrifft allgemein LED-Modul (1) mit einem Schaltungsträger (5) mit einer Oberseite (6) und einer von der Oberseite (6) abgewandten Unterseite (7), wenigstens einem LED-Leuchtmittel (10), das an der Unterseite (7) des Schaltungsträgers (5) angeordnet ist, und einem flächigen Kühlelement (15), das an der Unterseite (7) des Schaltungsträgers (5) angeordnet ist und wenigstens eine Aussparung (20) aufweist, in deren Aussparungsbereich sich wenigstens eines der LED-Leuchtmittel (10) befindet. Ferner betrifft die Erfindung eine Leuchte (50) mit einem solchen LED-Modul (1) sowie ein Verfahren zum Herstellen eines LED-Moduls (1).

## Beschreibung

### Technisches Gebiet

Die vorliegende Erfindung betrifft allgemein ein LED-Modul sowie ein Verfahren zum Herstellen eines solchen LED-Moduls. Insbesondere betrifft die vorliegende Erfindung auch jedwede Art von Leuchten, die ein oder mehrere derartige LED-Module umfassen.

### Hintergrund

LED-Module der eingangs genannten Art umfassen im einfachsten Fall eine oder mehrere Leuchtdioden (LED), die auch als LED-Leuchtmittel bezeichnet werden, einen Schaltungsträger wie beispielsweise eine Leiterplatte, auf der ein oder mehrere LED-Leuchtmittel aufgebracht sind, sowie ein beispielsweise flächiges Kühlelement, um die in Betrieb von einem oder mehreren LED-Leuchtmitteln erzeugte Wärme abzuführen und beispielsweise an die Umgebung abzugeben.

Derartige LED-Module werden beispielsweise in Leuchten jedweder bekannter Art zur Beleuchtung verwendet. Leuchte im vorliegenden Sinne sind Gegenstände, die der Beleuchtung dienen und dazu eine Aufnahmevorrichtung für ein Leuchtmittel besitzen oder ein fest installiertes Leuchtmittel enthalten. Als Leuchtmittel ist beispielsweise ein LED-Modul der hier offenbarten Art einsetzbar.

Eine Leuchten-Moduleinheit, die einen Schaltungsträger mit darauf angebrachten LED-Leuchtmitteln umfasst, ist aus der DE 20 2009 009 802 U1 bekannt. Bei dieser bekannten Leuchten-Moduleinheit ist auf der der Abstrahlseite der LED-Leuchtmittel abgewandten Seite des Schaltungsträgers ein Bodenelement vorgesehen, das auch als Kühlelement zum Abführen von Wärme aus dem Schaltungsträger und dem darin aufgebrachten Leuchtmittel dient.

Durch diese Ausgestaltung ist die Abfuhr von Wärmeenergie nur begrenzt möglich. Auch die Gesamtdicke der Leuchten-Moduleinheit ist relativ groß. Darüber hinaus kann es bei diesem Aufbau bei höheren Leistungen der LED zu mangelnder Kühlung kommen. Hierdurch kann auch die Betriebstemperatur der LED selbst relativ hoch sein.

Ein dem genannten Stand der Technik sehr ähnlicher Multilayer-Leiterplattenaufbau mit LED ist aus der DE 10 2008 004 621 A1 bekannt. Hier sind die LED auf Lagen aus Stanzbändern mechanisch fixiert. Die ein oder mehreren Stanzbänder, die auch als Kühlblech dienen können, sind wiederum auf der der Abstrahlseite abgewandten Seite angeordnet, was zu den genannten Nachteilen führen kann.

Auch die WO 2010/111721 A1 zeigt einen ähnlichen Aufbau. Hier ist eine Bodenplatte mit guter Wärmeleitfähigkeit als integrierte Kühlplatte vorgesehen. Wiederum ist diese Bodenplatte auf der gleichen Seite der Leiterplatte angeordnet wie bei dem zuvor genannten Stand der Technik. Dadurch sind auch bei diesem bekannten Aufbau die bereits genannten Nachteile zu erwarten.

Schließlich ist aus der DE 20 201 005 878 U1 ein Beleuchtungssystem mit mehreren LED-Modulen bekannt, die auf Kontaktschienen aufliegen. Die Kontaktschienen dienen unter anderem zur Kühlableitung. Auch diese Kontaktschienen sind wiederum auf der der Abstrahlseite der Leuchtmodule abgewandten Seite angeordnet und damit mit den bekannten Nachteilen behaftet.

Die vorliegende Erfindung ist darauf gerichtet, ein oder mehrere der genannten Aspekte der Aufbauten gemäß dem Stand der Technik zumindest zum Teil zu verbessern.

### Darstellung der Erfindung

Gemäß einem ersten Aspekt der vorliegenden Erfindung ist ein LED-Modul bereitgestellt, das einen Schaltungsträger mit einer Oberseite und einer der Oberseite abgewandten Unterseite umfasst. Wenigstens ein LED-Leuchtmittel ist am Schaltungsträger derart angeordnet, dass ein wesentlicher Teil der Lichtabstrahlung von der Unterseite aus erfolgt. An der Unterseite des Schaltungsträgers ist wenigstens ein Kühlelement angeordnet, das wenigstens eine Aussparung aufweist, in deren Bereich sie wenigstens eines der LED-Leuchtmittel findet. Ein wesentlicher Teil der Lichtabstrahlung bedeutet, dass mehr Licht an der Unterseite als an der Oberseite des Schaltungsträgers abgestrahlt wird. Insbesondere ist es auch möglich, dass an der Oberseite kein Licht abgestrahlt wird. Die Strahlungsrichtung ist dabei durch das Kühlblech hindurch an der Unterseite.

Gemäß einem weiteren Aspekt betrifft die vorliegende Erfindung eine Leuchte mit einem LED-Modul der vorgenannten Art.

Nach einem weiteren Aspekt der vorliegenden Erfindung ist ein Verfahren zum Herstellen eines LED-Moduls offenbart, das die vorliegenden Verfahrensschritte umfasst. So wird wenigstens ein LED-Leuchtmittel an einem Schaltungsträger angebracht. Wenigstens ein Kühlelement, das wenigstens eine Aussparung aufweist, wird auf der gleichen Seite des Schaltungsträgers angebracht wie das wenigstens eine LED-Leuchtmittel, und zwar so, dass sich wenigstens eines der LED-Leuchtmittel im Aussparungsbereich des Kühlelements befindet.

Der vorliegenden Erfindung liegt der Gedanke zugrunde, erstmals auf der gleichen Seite eines Schaltungsträgers sowohl ein LED-Leuchtmittel als auch das zugehörige flächige Kühlelement anzubringen. Dadurch könnte einerseits die Dicke des Gesamtaufbaus aus Schaltungsträger, LED-Leuchtmittel und Kühlelement sehr gering gehalten werden, zum anderen könnte es auch möglich sein, die Wärmeabfuhr zu verbessern. Insbesondere könnte dadurch auch die Betriebstemperatur der LED an sich minimiert werden und folglich die Lebensdauer der LED maximiert werden. Indem in dem vorzugsweise flächigen Kühlelement ein einem oder mehreren LED-Leuchtmitteln entsprechender Aussparungsbereich vorhanden ist, ist es trotz dieses neuartigen Schichtaufbaus möglich, dass die LED Licht in der Richtung abstrahlt, in der das Kühlelement sich befindet. Gleichzeitig ist es aber ermöglicht, dass das Kühlelement unmittelbar im Bereich der LED angeordnet ist, was eine optimale Wärmeabfuhr bietet. Aufgrund des hierin offenbarten Aufbaus eines LED-Moduls kann ein beispielsweise flächiges Kühlelement wie ein Kühlblech plan auf dem Schaltungsträger aufliegen, was zur Optimierung der Wärmeabfuhr am Wärmeentstehungspunkt, d.h. der LED, führt. Das Kühlblech besteht beispielsweise aus Aluminium und hat z.B. eine Stärke von 0,50 mm bis 4,00 mm, insbesondere 1,00 mm bis 2,50 mm und beispielsweise eine Stärke von 1,50 mm. Auch jegliche Zwischenstärken sind je nach Einsatzgebiet und Materialien verwendbar.

### Kurze Beschreibung der Erfindung

Fig. 1 zeigt eine perspektivische Explosionsdarstellung einer beispielhaften Ausführungsform eines erfindungsgemäßen LED-Moduls,
Fig. 2 zeigt eine Unteransicht des LED-Moduls der Fig. 1,
Fig. 3 zeigt eine Schnittansicht entlang der Linie B-B in Fig. 2,
Fig. 3a zeigt ein Detail A in Fig. 3, wobei allerdings die Schnittansicht in Fig. 3a um 90° im Uhrzeigsinn gedreht ist,
Fig. 4 zeigt eine Seitenansicht von links des LED-Moduls der Fig. 2,
Fig. 5 zeigt eine Vorderansicht des LED-Moduls gemäß Fig. 2, und
Fig. 6 zeigt eine schematische Vorderansicht einer erfindungsgemäßen Leuchte mit LED-Modul.

### Detaillierte Beschreibung beispielhafter Ausführungsformen

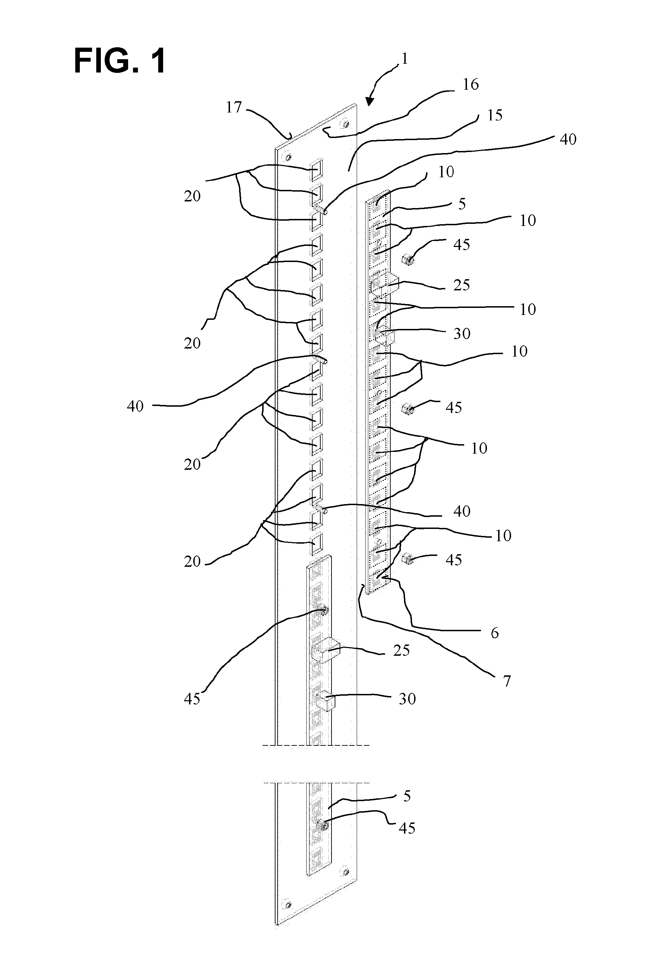

Unter Bezugnahme auf die Fig. 1 bis 5 wird nachfolgend eine beispielhafte Ausführungsform eines erfindungsgemäßen LED-Moduls 1 näher erläutert. Das LED-Modul 1 besteht grundsätzlich aus einem Schaltungsträger wie z.B. einer Leiterplatte 5, die eine Leiterplattenoberseite 6 und eine Leiterplattenunterseite 7 aufweist, einem oder mehreren LED-Leuchmitteln 10 und einem vorzugsweise flächigen Kühlelement wie beispielsweise ein Kühlblech 15. Das Kühlblech 15 weist eine Kühlblechoberseite 16 und eine der Oberseite abgewandte Kühlblechunterseite 17 auf. Das Kühlblech 16 besitzt bei diesem Ausführungsbeispiel eine größere Anzahl von Aussparungen 20, die sich von der Kühlblechoberseite 16 bis zur Kühlblechunterseite 17 erstrecken. Die Aussparrungen 16 bilden somit Durchbruchsöffnungen in dem Kühlblech 15. Hier sind sie beispielsweise quadratisch ausgebildet, sie können aber auch jegliche andere Form haben wie z.B. kreisförmig, rechteckig, vieleckig, oval etc.

Bei diesem Ausführungsbeispiel der vorliegenden Erfindung sind die Aussparungen 20 in regelmäßigen Abständen zueinander angeordnet und sie sind über im Wesentlichen die gesamte Länge des Kühlblechs 15 verteilt. Die Aussparungen 20 können in etwa der Größe eines Leucht-LED-Leuchtmittels 10 entsprechen. Bei dem in den Figuren 1 bis 5 gezeigten Ausführungsbeispiel sind eine der Anzahl von Aussparungen 20 entsprechende Anzahl von LED-Leuchtmitteln 10 an oder in der Leiterplatte 5 angeordnet und zwar derart, dass die LED-Leuchtmittel 10 ihre Hauptabstrahlrichtung von der Leiterplattenunterseite 7 aus haben. Im vorliegenden Fall also in Richtung des in der Explosionsdarstellung gemäß der Fig. 1 an der Leiterplattenunterseite 7 anzubringenden Kühlblechs 15. Die Anordnung der LED-Leuchtmittel 10 am oder in der Leiterplatte 5 ist dergestalt, dass jeweils ein LED-Leuchtmittel 10 sich in Überdeckung mit dem Aussparungsbereich jeweils einer Aussparung 20 im Kühlblech 15 befindet.

An der Leiterplatte 5 können die für die LED-Leuchmittelversorgung notwendigen Schaltungen aufgebracht sowie weitere elektronische Bauteile 25, 30 wie zum Beispiel Vorwiderstände vorhanden sein. Im vorliegenden Fall sind die eine räumliche Ausdehnung aufweisenden elektronischen Bauteile 25, 30 auf der Leiterplattenoberseite 6 angeordnet, so dass die Leiterplattenunterseite 7 im Wesentlichen eben ist. Bei dem hier gezeigten Ausführungsbeispiel ist, wie insbesondere in der Fig. 1 ersichtlich, ein Kühlblech 15 mit zwei Leiterplatten 5 zu bestücken. Alternativ ist es auch möglich, eine größere oder kleinere Anzahl von Leiterplatten mit den darin befindlichen LED-Leuchtmitteln 10 etc. an einem Kühlblech 15 anzubringen.

Beispielsweise erfolgt das Anbringen einer Leiterplatte 5 auf der Kühlblechoberseite 16. Zur Führung sind hier Stiftschrauben 40 an dem Kühlblech 15 vorgesehen, die in entsprechenden Öffnungen in die Leiterplatte 5 hineinragen. Mittels Schraubenmuttern 45 erfolgt die endgültige Befestigung (lösbar) eines Kühlblechs 5 an dem Kühlblech 15. Andere Befestigungsmöglichkeiten sind aber ebenfalls einsetzbar.

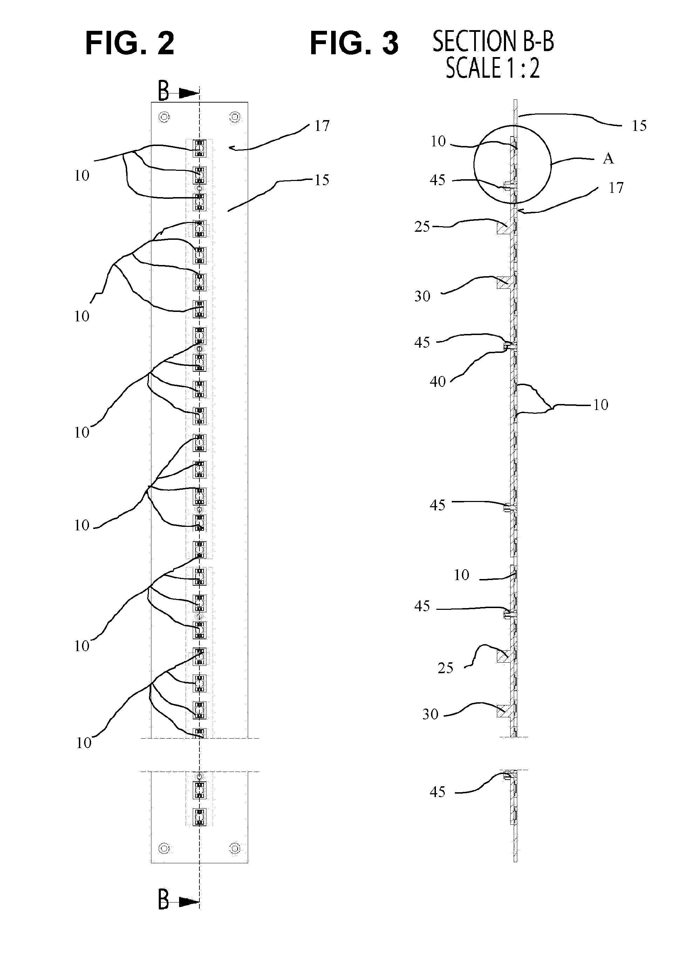

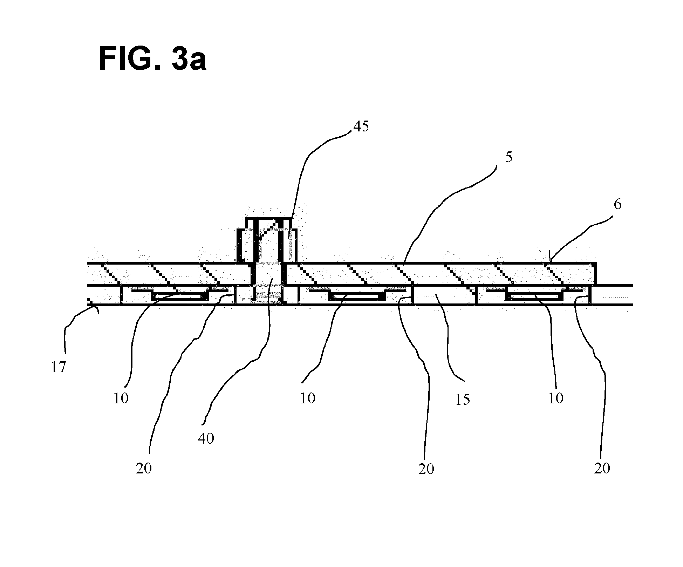

Wie z.B. aus der Schnittdarstellung der Fig. 3 ersichtlich, ragen bei diesem Ausführungsbeispiel die Leuchtmittel 10 jeweils in die Aussparungen 20 im Kühlblech 15. Die Kühlblechoberseite 16 kontaktiert im Wesentlichen flächig die Leiterplattenunterseite 17, wodurch eine effektive Wärmeabfuhr über das Kühlblech erfolgen kann.

Bei einer hier nicht dargestellten Ausführungsform ist es auch möglich, dass die LED-Leuchtmittel 10 nicht in die Aussparungen 20 hineinragen, sondern sich nur in deren Aussparungsbereich befinden. Eine möglichst geringe Gesamtdicke eines LED-Moduls 1 wird allerdings dann erzielt, wenn die LED-Leuchtmittel 10 in der Aussparung selbst angeordnet sind und deren Unterseite möglichst mit der Kühlblechunterseite 17 bündig abschließt.

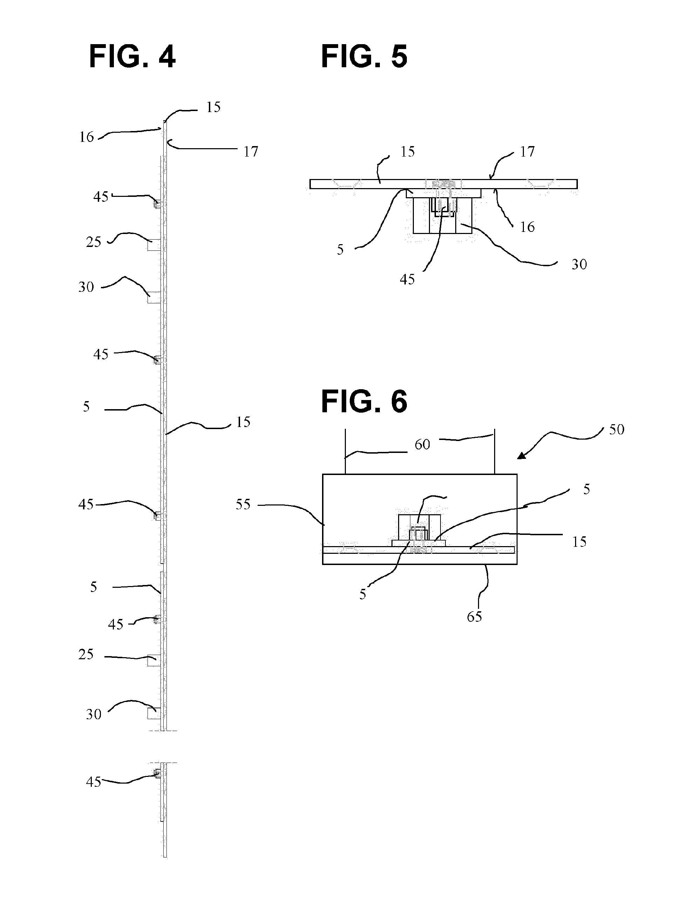

Eine beispielhafte Ausführungsform einer erfindungsgemäßen Leuchte 50 ist in der Fig. 6 schematisch gezeigt. In einem Leuchtengehäuse 55, das an Aufhängekabeln 60 beispielsweise an einer Decke befestigbar ist, ist ein LED-Modul 1, wie es unter Bezugnahme auf die Fig. 1 bis 5 erläutert wurde, untergebracht. Im Betrieb wird dem LED-Modul 1 Energie zugeführt, so dass die LED-Leuchtmittel 10 in der in Fig. 6 gezeigten Darstellung nach unten, von der Kühlblechunterseite 17 heraus, Licht abstrahlen. Im gezeigten Ausführungsbeispiel ist eine transparente Abdeckung 65 Teil des Leuchtengehäuses 55. Diese Abdeckung kann aber auch weggelassen werden. Unter Umständen ist es auch möglich, dass LED-Modul 1 unmittelbar an Aufhängeseilen 65 oder dergleichen für eine hängende Anordnung vorzusehen. Alternativ kann das LED-Modul 1 auch an Wände geschraubt, an irgendwelche Gegenstände angebracht oder lösbar oder anderweitig fest fixiert sein.

Wie bereits aus voranstehenden Ausführungen hervorgeht, kann ein erfindungsgemäßes LED-Modul 1 beispielsweise wie folgt gefertigt werden. Zuerst wird eine Leiterplatte 5 mit den notwendigen Schaltungen versehen und darin in die LED-Leuchtmittel 10 befestigt. Auf ein vorgestanztes Kühlblech 15 werden dann über die Stiftschrauben 40 ein oder mehrere vorgefertigte Leiterplatten 5, die bereits mit LED-Leuchtmitteln 10 versehen sind, aufgesteckt und fixiert, z.B. verschraubt. Dabei wird gemäß dem gezeigten Ausführungsbeispiel eines LED-Moduls 1 jeweils eine Aussparung 20 in dem Kühlblech einem LED-Leuchtmittel 10 zugeordnet. Es ist aber auch möglich, dass die Aussparungen 20 so geformt werden, dass zwei oder mehr LED-Leuchtmittel 10 einer Aussparung 20 zuzuordnen sind. Entsprechend würden dann in einer Aussparung 10 zwei oder mehr LED-Leuchtmittel 10 angeordnet sein.

Im Übrigen kann das Schaltungsträgermaterial, hier beispielsweise die Leiterplatte 5, auch transparent ausgebildet werden, so dass die LED-Leuchtmittel 10 nicht nur von der Leiterplattenunterseite 7 heraus abstrahlen, sondern auch Licht in Richtung der Leiterplattenoberseite 6 abgeben. Eine solche Ausbildung ist insbesondere bei Folienträgern denkbar. Damit können geeignete Lichteffekte erzielbar sein. Im Übrigen sind auch alle möglichen Schaltungsträger, die auf dem Markt bekannt sind, für die Verwendung in einem LED-Modul 1 gemäß der vorliegenden Erfindung geeignet, insbesondere auch flexible Schaltungsträger wie Folienträger etc.

Abschließend ist noch anzumerken, dass eine Leiterplatte 5 dann auch mit dem für den Betrieb eines LED-Leuchtmittels 10 notwendigen Elektronikbauteilen 25, 30 wie z.B. Vorwiderstände versehen werden, bevor sie dann mit dem Kühlblech 15 verschraubt werden. Die Verschraubung ist allerdings nicht zwingend notwendig, es sind auch Verklebungen, Verklemmungen oder anderweitige Fixierungen für ein Kühlblech oder eine Leiterplatte 5 verwendbar.

Als LED-Leuchtmittel sind insbesondere SMD-Leuchtmittel verwendbar.

## Patentansprüche

1. LED-Modul (1) mit:
- einem Schaltungsträger (5) mit einer Oberseite (6) und einer von der Oberseite (6) abgewandten Unterseite (7),
- wenigstens einem LED-Leuchtmittel (10), das an der Unterseite (7) des Schaltungsträgers (5) angeordnet ist, und
- einem flächigen Kühlelement (15), das an der Unterseite (7) des Schaltungsträgers (5) angeordnet ist und wenigstens eine Aussparung (20) aufweist, in deren Aussparungsbereich sich wenigstens eines der LED-Leuchtmittel (10) befindet.

2. LED-Modul nach Anspruch 1, bei der die Anzahl an Aussparungen (20) der Anzahl von LED-Leuchtmitteln (10) entspricht.

3. LED-Modul nach Anspruch 1 oder 2, bei der der Schaltungsträger (5) mit Leiterbahnen für das wenigstens eine LED-Leuchtmittel (10) versehen ist.

4. LED-Modul nach einem der voranstehenden Ansprüche, bei der der Schaltungsträger eine Leiterplatte (5) ist.

5. LED-Modul nach einem der voranstehenden Ansprüche, bei der das Kühlelement (15) eine Oberseite (16) und eine Unterseite (17) aufweist und zumindest mit einer Teilfläche der Oberseite (16) die Schaltungsträgerunterseite (7) kontaktiert.

6. LED-Modul nach Anspruch 5, bei der die wenigstens eine Aussparung (20) eine Durchgangsöffnung ist, die sich von der Kühlelementunterseite (17) bis zur Kühlelementoberseite (16) erstreckt.

7. LED-Modul nach einem der voranstehenden Ansprüche, bei der der Schaltungsträger (5) und das Kühlelement (15) lösbar miteinander verbunden sind, insbesondere durch eine Verschraubung.

8. LED-Modul nach einem der Ansprüche 1-6, bei der der Schaltungsträger (5) und das Kühlelement (15) nicht lösbar miteinander verbunden sind, insbesondere durch eine Verklebung.

9. LED-Modul nach einem der voranstehenden Ansprüche, bei der das Kühlelement ein Kühlblech (15) ist.

10. LED-Modul nach einem der voranstehenden Ansprüche, bei der das LED-Leuchtmittel eine SMD-Leuchtdiode (10) ist.

11. Leuchte (50) mit einem LED-Modul (1) nach einem der voranstehenden Ansprüche.

12. Verfahren zum Herstellen eines LED-Moduls (1), mit den Verfahrensschritten:
- Aufbringen von wenigstens einem LED-Leuchtmittel (10) an einer Unterseite (7) eines Schaltungsträgers (5), und
- Anbringen eines Kühlelements (15), das wenigstens eine Aussparung (20) aufweist, an der Unterseite (7) des Schaltungsträgers (5), so dass sich wenigstens eines der LED-Leuchtmittel (10) im Aussparungsbereich befindet.
